# EUROPEAN PATENT APPLICATION

(11) **EP 4 779 669 A1**
(43) Date of publication of application: **22.07.2026**
(21) Application number: 24865651.4
(22) Date of filing: 16.07.2024
(51) Int. Cl.: H01H 45/04, H01H 9/02, H05K 1/02

(54) **BATTERY DISCONNECT DEVICE**

(30) Priority: 13.09.2023 KR 20230121858
(71) Applicant: LS E-MOBILITY SOLUTIONS CO., LTD., Cheongju-si, Chungcheongbuk-do 28439 (KR)
(72) Inventor: KIM, Do Hyeong, Cheongju-si, Chungcheongbuk-do 28439 (KR)
(74) Representative: K&L Gates LLP
(86) International application number: PCT/KR2024/010193
(87) International publication number: WO 2025/058208

(57) **Abstract**

A battery disconnect device is disclosed. The battery disconnect device according to one aspect of the present invention may comprise: and a body unit on which a relay for disconnecting or supplying electricity is mounted; and a substrate, which is coupled to one surface of the body unit, is electrically connected to the relay, and includes a control unit for controlling whether the relay disconnects or supplies electricity.

## Description

### Technical Field

The disclosure relates to a battery disconnect device, and more particularly, to a battery disconnect device applied to an electric vehicle.

### Background Art

The trend of restricting the use of fossil fuels to suppress climate change continues. This trend is affecting not only a power generation sector for generating electricity, but also everyday life.

Accordingly, research is actively being conducted to move away from conventional vehicles that generate power using fossil fuels, such as gasoline or diesel, and to drive vehicles using electricity or hydrogen, such as electric vehicles (EVs), hybrid electric vehicles (HEVs), and hydrogen vehicles (HVs).

The EV, HEV, HV, and the like essentially use batteries to supply power for driving. A battery disconnect unit (BDU) is essential to directly supply or cut off battery power to an electric vehicle.

The BDU is electrically connected to a battery management system (BMS) that determines whether to supply or cut off power to the electric vehicle, and the BDU is controlled by the BMS.

In the related art, the BDU and BMS were manufactured as separate devices. To exchange electrical signals between the BDU and BMS, the signals had to pass through several signal transmission media, such as lines, terminals, and connectors, which resulted in a decrease in stability of the electrical signals. In particular, when the BDU and BMS are installed in the electric vehicle, the stability of the electrical signals between the BDU and BMS directly affects performance and safety of the electric vehicle.

### Disclosure of Invention

### Technical Problem

The disclosure is intended to solve the above problems, and an aspect of the disclosure is to provide a battery disconnect device that improves stability of electrical signals between a BUD and a BMS.

The problems to be solved in the disclosure may not be limited to the aforementioned, and other problems to be solved by the disclosure, which are not mentioned, will be obviously understood by a person skilled in the art based on the following description.

### Solution to problem

According to one aspect of the disclosure, there is provided a battery disconnect device including: a body part including a relay on which a relay is mounted, the relay being configured to cut off or supply electricity; and a substrate coupled to one surface of the body part, electrically connected to the relay, and including a controller configured to control whether the relay cuts off or supplies electricity.

The battery disconnect device may further include a heat dissipation part arranged on one surface of the substrate and configured to protect the substrate or dissipate heat to outside.

The body part may include first body holes communicating with the heat dissipation part.

The substrate may be coupled to a lower side of the body part.

The battery disconnect device may further include a first cover covering the one surface of the body part, and the heat dissipation part may be arranged on another surface of the body part.

The first cover may include cover holes through which heat is dissipated, and the heat dissipation part may include dissipation holes through which heat is dissipated.

The relay may include a terminal protruding to be directly connected to the substrate through the body part, and the substrate may include a connecting portion connected to the terminal.

The body part may include a second body hole through which the terminal passes.

The terminal may be arranged as a plurality of terminals, and the connecting portion may include: a first connecting portion coupled to the substrate; a second connecting portion extending from one side of the first connecting portion and formed to surround one of the plurality of terminals; and a third connecting portion extending from another side of the second connecting portion and formed to surround another one of the plurality of terminals.

The body part may include: a relay installation portion formed to surround at least one surface of the relay; and a relay cover portion covering the relay.

The body part may further include a fixing protrusion arranged inside the relay installation portion, and the fixing protrusion may be formed to protrude from the body part and fix the relay.

The fixing protrusion may include: a first fixing protrusion coming into contact with one surface of a corner of the relay; and a second fixing protrusion extending from the first fixing protrusion and coming into contact with another surface of the corner of the relay.

The relay installation portion may include a first coupling member for coupling with the relay cover portion, the relay cover portion may include a second coupling member coupled to the first coupling member, and the relay cover portion may be coupled to the relay installation portion by coupling the first coupling member and the second coupling member.

The body part may have an accommodation space that accommodates the heat dissipation part, and an end of the heat dissipation part may be located at a higher position than an end of the body part. At this time, the heat dissipation part may be exposed to outside.

According another aspect of the disclosure, there is provided a method of manufacturing a battery disconnect device, the method including: a body part preparation step of preparing a body part having a relay installation portion on which a relay is mounted; a substrate coupling step of coupling a substrate including a controller to one surface of the body part, the controller controlling whether the relay cuts off or supplies electricity; a relay mounting step of mounting the relay to the relay installation portion; and a relay covering step of covering a relay cover portion on the relay.

The method of manufacturing the battery disconnect device may further include a heat dissipation part arrangement step of arranging a heat dissipation part, which dissipates heat to outside, on the substrate.

### Advantageous Effects of Invention

According to the configuration, a battery disconnect device according to the embodiment of the disclosure has the advantage of improving the stability of electrical connection between a relay and a substrate, by virtue of a direct connection between the substrate corresponding to a BMS and the relay without using a separate cable.

A heat dissipation part which is arranged on one surface of the substrate minimizes heat of the substrate from being transferred to the relay, thereby suppressing the relay from malfunctioning or being damaged due to heat.

### Brief Description of Drawings

FIG. 1 is a perspective view of appearance of a battery disconnect device according to an embodiment of the disclosure.
FIG. 2 is an exploded perspective view of a battery disconnect device according to an embodiment of the disclosure.
FIG. 3 is a perspective view of a substrate of a battery disconnect device according to an embodiment of the disclosure.
FIG. 4 is a perspective view of a body part of a battery disconnect device according to an embodiment of the disclosure.
FIG. 5 is a flowchart of a method of manufacturing a battery disconnect device according to an embodiment of the disclosure.
FIG. 6 is a view of a state where a relay of a battery disconnect device according to an embodiment of the disclosure is mounted on a body part.
FIG. 7 is a view of a state where a substrate of a battery disconnect device according to an embodiment of the disclosure is mounted on a body part.
FIG. 8 is a perspective view of a battery disconnect device according to an embodiment of the disclosure, viewed from bottom.
FIG. 9 is a perspective view of a body part of a battery disconnect device according to another embodiment of the disclosure, viewed from bottom.
FIG. 10 is a perspective view of a state where a heat dissipation part is mounted on a body part of a battery disconnect device according to another embodiment of the disclosure.
FIG. 11 is a lateral view of a battery disconnect device according to another embodiment of the disclosure.

### Mode for the Invention

Hereinafter, embodiments of the disclosure will be described in detail with reference to the accompanying drawings, so as to be easily implemented by those skilled in the art. The disclosure may be implemented in many different forms and is not limited to the embodiment described herein. To clearly explain the disclosure, parts not related to the description have been omitted in the drawings, and the same or equivalent components are given the same reference numerals throughout the specification.

The words and terms used in the disclosure and claims are not to be construed as limited in their usual or dictionary meanings, but should be interpreted with meaning and concepts consistent with the technical idea of the disclosure according to the principle that the inventor can define terms and concepts in order to explain his or her invention in the best way.

Therefore, the embodiment described in the disclosure and the configuration shown in the drawings correspond to a preferred embodiment of the disclosure, and do not represent all of the technical ideas of the disclosure, so the corresponding configuration may be replaced with various equivalents and modified examples at the time that the disclosure is filed.

Terms such as "include" or "has" are used herein and should be understood that they are intended to indicate an existence of several components, functions or steps, disclosed in the specification, and it is also understood that greater or fewer components, functions, or steps may likewise be utilized.

It will be understood that when an element is referred to as being arranged at "front," "rear," "top," or "bottom" of another element, it includes, unless otherwise specifically stated, not only a case where the element is arranged directly on "front," "rear," "top," or "bottom" of another element, but also a case where an intervening element is present between the elements. In addition, when an element is "connected" to another element, it includes, unless otherwise stated, not only being directly connected to each other, but also indirectly connected to each other.

Hereinafter, a battery disconnect device according to an embodiment of the disclosure will be described in detail with reference to the drawings.

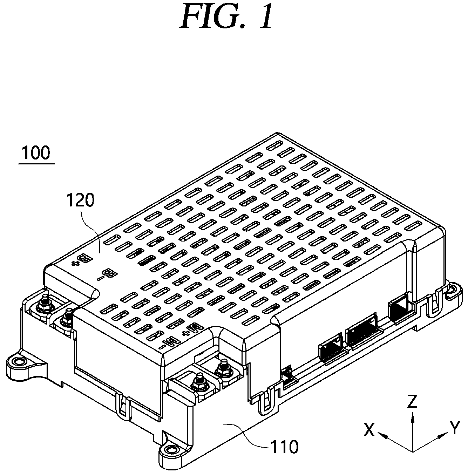

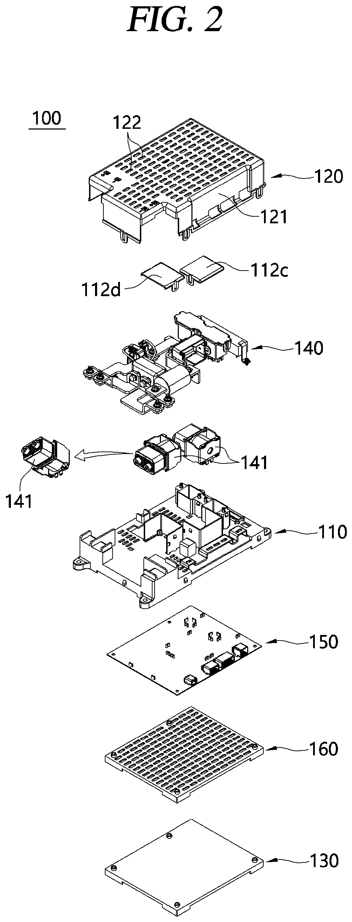

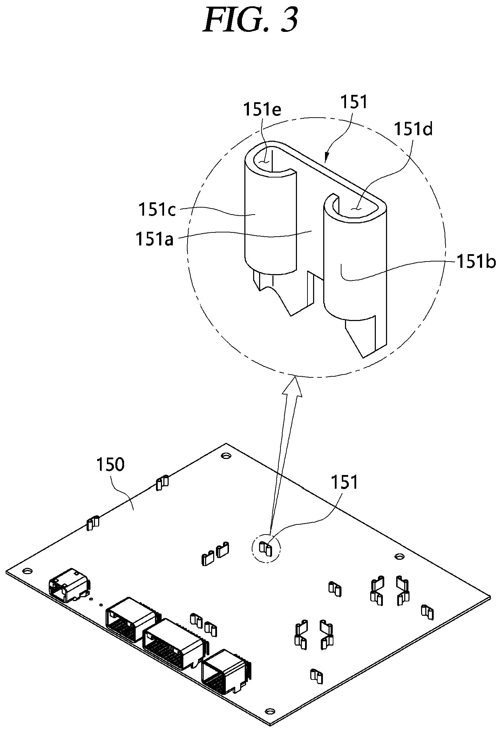

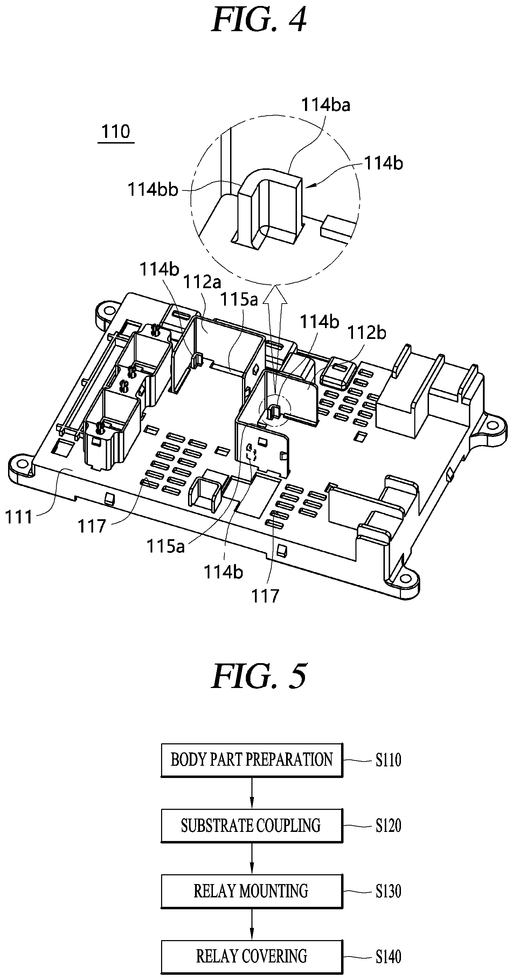

FIG. 1 is a perspective view of appearance of a battery disconnect device according to an embodiment of the disclosure, FIG. 2 is an exploded perspective view of a battery disconnect device according to an embodiment of the disclosure, FIG. 3 is a perspective view of a substrate of a battery disconnect device according to an embodiment of the disclosure, and FIG. 4 is a perspective view of a body part of a battery disconnect device according to an embodiment of the disclosure.

Referring to FIGS. 1 and 4, a battery disconnect device 100 according to an embodiment of the disclosure includes a body part 110, a first cover 120, a BDU component 140 including a relay 141, a substrate 150, a heat dissipation part 160, and a second cover 130.

The body part 110 is formed to support the BDU component 140.

As shown in FIG. 4, the body part 110 includes a support portion 111, relay installation portions 112a and 112b, and fixing protrusions 114a and 114b.

First body holes 117 penetrating the support portion 111 is formed in the support portion 111. Accordingly, external air can move through the support portion 111 through the first body holes 117.

Each of the relay installation portions 112a and 112b is formed to surround at least one side surface of the relay 141. The relay installation portions 112a and 112b may be arranged as a plurality of relay installation portions.

The fixing protrusions 114a and 114b are arranged inside the relay installation portions 112a and 112b. The fixing protrusions 114a and 114b are formed to protrude from the support portion 111 to fix the relays 141. The fixing protrusions 114a and 114b may be arranged as a plurality of fixing protrusions.

One fixing protrusion 114b of the plurality of fixing protrusions includes a first fixing protrusion 114ba and a second fixing protrusion 114bb.

The first fixing protrusion 114ba is in contact with one surface of a corner of the relay 141.

The second fixing protrusion 114bb extends from the first fixing protrusion 114ba and is in contact with the other surface of the corner of the relay 141.

As the first fixing protrusion 114ba comes into contact with the one surface of the corner of the relay 141 and the second fixing protrusion 114bb comes into contact with the other surface of the corner of the relay 141, the relay 141 is fixed by the first fixing protrusion 114ba and the second fixing protrusion 114bb.

The first cover 120 is formed to cover an upper side of the body part 110. The first cover 120 is coupled to the body part 110. At this time, the first cover 120 includes a first cover body 121 that accommodates the BDU component 140 together with the body part 110.

Cover holes 122 are formed on an upper side of the first cover body 121 to allow heat generated by the operation of the BDU component 140 to be discharged to outside of the first cover 120.

According to various embodiments of the disclosure, each of the cover holes 122 may include a foreign substance shielding member (not shown) which minimizes the inflow of foreign substances from outside while not interfering with the dissipation of heat. The foreign substance shielding member may be formed in a mesh shape and arranged in the cover hole 122.

The battery disconnect unit (BDU) component 140 includes a relay 141 that cuts off electricity and various electronic components for operating the relay 141.

The relay 141 may be electrically connected to a battery (not shown) of an electric vehicle, and may supply power of the battery to the electric vehicle, for example, a motor and various electronic devices of the electric vehicle or cut off the power.

The substrate 150 is coupled to one surface of the body part 110. For example, the substrate 150 is coupled to a lower side of the body part 110. The body part 110 is arranged between the relay 141 and the substrate 150. In this way, as the body part 110 is arranged between the relay 141 and the substrate 150, the body part 110 blocks heat of the substrate 150 from being transferred to the relay 141, thereby suppressing damage or malfunction of the relay 141 due to the heat of the substrate 150.

The substrate 150 is electrically connected to the relay 141.

The substrate 150 includes a controller (not shown) that controls whether to supply or cut off power (electricity) to or from the relay 141. The controller is electrically connected to the relay 141.

The controller transmits an electrical signal to the relay 141 to control the operation of the relay 141. That is, the relay 141 may be controlled by the controller to supply or cut off power from the battery to the electric vehicle.

The relay 141 includes a terminal 141a for direct connection to the substrate 150. The terminal 141a protrudes from one surface of the relay 141 to be connected to the substrate 150 through the body part 110.

Second body holes 115a and 115b through which the terminals 141a pass are formed in the body part 110. That is, the terminals 141a pass through the second body holes 115a and 115b to be connected to the substrate 150.

As shown in FIG. 3, the substrate 150 includes connecting portions 151 connected to the terminals 141a.

The corresponding connecting portion 151 includes a first connecting portion 151a coupled to the substrate 150, a second connecting portion 151b extending from one side of the first connecting portion 151a, and a third connecting portion 151c extending from the other side of the first connecting portion 151a.

The second connecting portion 151b is formed to be coupled while surrounding the terminal 141a. At this time, the second connecting portion 151b is formed to be tilted with respect to the first connecting portion 151a, and thus presses the terminal 141a, such that the terminal 141a is brought into smooth contact with the second connecting portion 151b.

The third connecting portion 151c is formed to be coupled while surrounding the terminal 141a. At this time, the third connecting portion 151c is formed to be tilted with respect to the first connecting portion 151a, and thus presses the terminal 141a, such that the terminal 141a is brought into smooth contact with the third connecting portion 151c.

The heat dissipation part 160 is arranged on one surface of the substrate 150. For example, the heat dissipation part 160 is arranged below the substrate 150. The heat dissipation part 160 dissipates the heat of the substrate 150 to the outside. At this time, the heat dissipation part 160 may be a heat sink. However, the heat dissipation part 160 is not limited to the heat sink, and may be a variety of devices that absorb heat and dissipate the heat to the outside.

In this way, the body part 110, the substrate 150, and the heat dissipation part 160 are sequentially stacked. Accordingly, the heat dissipation part 160 can stably discharge the heat of the substrate 150 to the outside without interfering with the relay 141.

The first cover 130 is formed to cover the heat dissipation part 160. The second cover 130 is coupled to the body part 110. According to various embodiments of the disclosure, the second cover 130 is not limited to being coupled to the body part 110, but may be coupled to the heat dissipation part 160.

The first body holes 117 of the body part 110 may communicate with the heat dissipation part 160. Accordingly, external air can move through the heat dissipation part 160 and the first body holes 117.

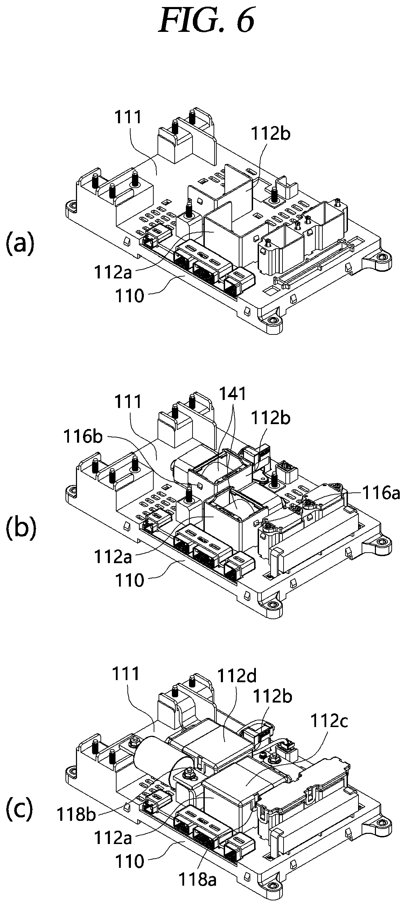

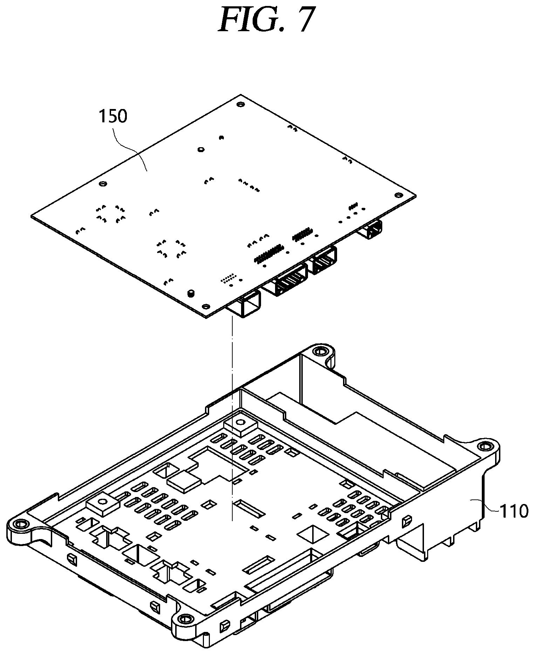

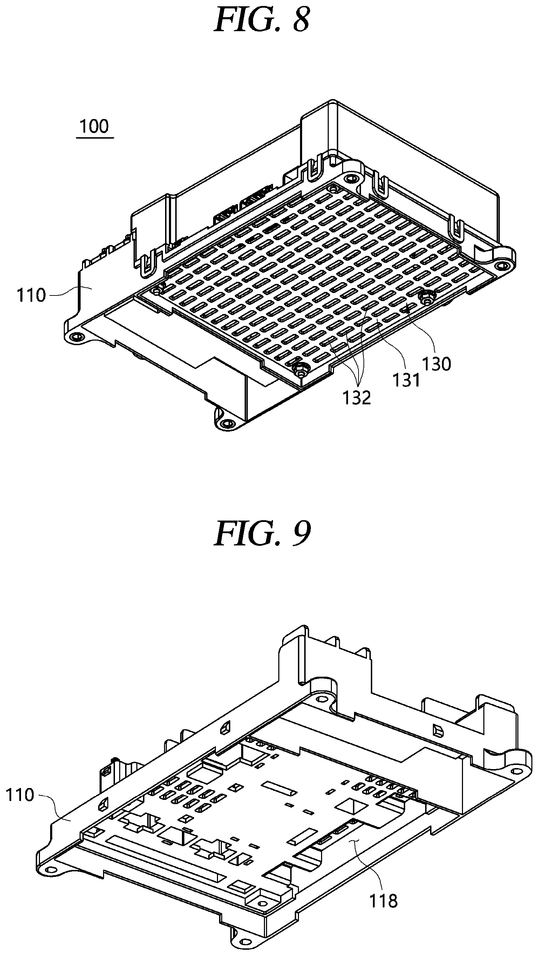

FIG. 5 is a flowchart of a method of manufacturing a battery disconnect device according to an embodiment of the disclosure, FIG. 6 is a view of a state where a relay of a battery disconnect device according to an embodiment of the disclosure is mounted on a body part, FIG. 7 is a view of a state where a substrate of a battery disconnect device according to an embodiment of the disclosure is mounted on a body part, and FIG. 8 is a perspective view of a battery disconnect device according to an embodiment of the disclosure, viewed from bottom.

Referring to FIGS. 5 to 8, a method of manufacturing a battery disconnect device according to an embodiment of the disclosure includes a body part preparation step (S110), a substrate coupling step (S120), a relay mounting step (S130), and a relay covering step (S140).

In the body part preparation step (S110), as shown in (a) of FIG. 5, the body part 110 including the relay installation portions 112a and 112b, on which the relays 141 are mounted, is prepared.

In the substrate coupling step (S120), as shown in FIG. 7, the substrate 150 including the controller, which controls whether the relay 141 cuts off or supplies electricity, is coupled to one surface of the body part 110.

In the relay mounting step (S130), as shown in (b) of FIG. 5, the relays 141 are mounted on the relay installation portions 112a and 112b. At this time, the relay installation portions 112a and 112b serve as guides during the installation process of the relays 141.

As shown in (c) of FIG. 5, the body part 110 includes relay cover portions 112c and 112d which cover exposed surfaces of the relays 141.

In the relay covering step (S140), the relay cover portions 112c and 112d cover the relays 141.

At this time, the relay installation portions 112a and 112b include first coupling members 116a and 116b, respectively, for coupling with the relay cover portions 112c and 112d, and the relay cover portions 112c and 112d each include second coupling members 118a and 118b, respectively, for coupling with the first coupling members 116a and 116b.

The first coupling members 116a and 116b may be formed to protrude from side surfaces of the relay installation portions 112a and 112b, respectively. The second coupling members 118a and 118b may have grooves, respectively, into which the corresponding first coupling members 116a and 116b are fixedly inserted. By coupling the first coupling members 116a and 116b and the second coupling members 118a and 118b, the relay cover portions 112c and 112d can be coupled to the relay installation portions 112a and 112b, respectively.

According to various embodiments of the disclosure, the configuration is not limited to the first coupling members 116a and 116b being formed in a protruding manner while the second coupling members 118a and 118b have the grooves, the first coupling members 116a and 116b and the second coupling members 118a and 118b may be formed with various structures that allow for coupling therebetween.

In this way, the relay installation portions 112a and 112b and the relay cover portions 112c and 112d suppress the relays 141 from being separated from the body part 110 due to vibrations generated while the electric vehicle is driven.

The method of manufacturing the battery disconnect device according to the embodiment of the disclosure may further include a heat dissipation part arrangement step of arranging a heat dissipation part, which dissipates heat to the outside, on the substrate.

As shown in FIG. 8, the second cover 130 is coupled to the body part 110.

At this time, the second cover 130 includes a second cover body 131 that accommodates the heat dissipation part together with the body part 110.

Holes 132 are formed on the upper side of the second cover body 131 such that heat from the heat dissipation unit can be dissipated to the outside of the second cover 130.

According to various embodiments of the disclosure, each of the holes 132 may include a foreign substance shielding member (not shown) which minimizes the inflow of foreign substances from outside without interference with the dissipation of heat. The foreign substance shielding member may be formed in a mesh shape and arranged in the hole 132.

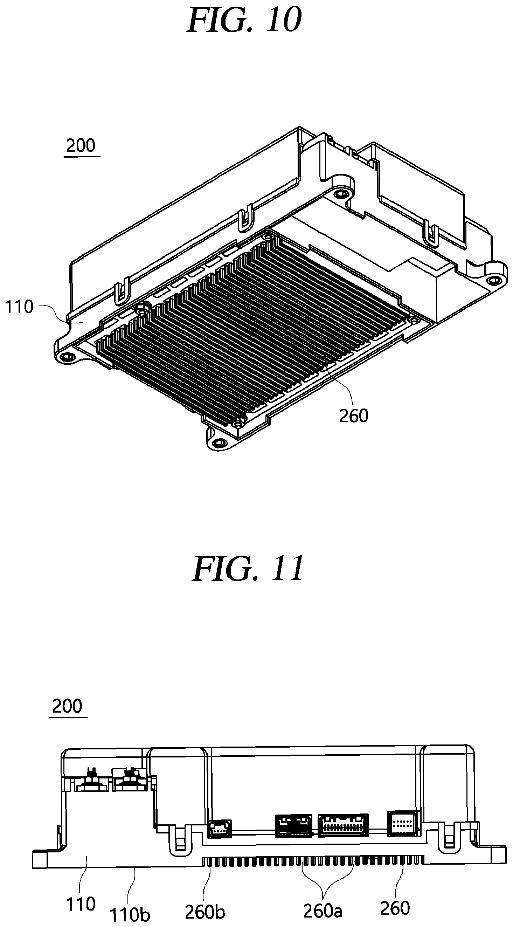

FIG. 9 is a perspective view of a body part of a battery disconnect device according to another embodiment of the disclosure, viewed from bottom, FIG. 10 is a perspective view of a state where a heat dissipation part is mounted on a body part of a battery disconnect device according to another embodiment of the disclosure, and FIG. 11 is a lateral view of a battery disconnect device according to another embodiment of the disclosure.

Referring to FIGS. 9 to 11, a battery disconnect device 200 according to another embodiment of the disclosure includes a heat dissipation part 260 in which the aforementioned heat dissipation part and the second cover are integrally formed, and a description of components equal or similar to those of the aforementioned embodiment is replaced with the aforementioned description, and the heat dissipation unit 260 will be explained in detail.

First, as shown in FIG. 9, an accommodation space 118 for accommodating the heat dissipation part 260 is formed in the body part 110.

As shown in FIG. 10, the heat dissipation part 260 is accommodated in the accommodation space 118.

At this time, the heat dissipation part 260 may be a heat sink manufactured by die-casting injection molding. The heat dissipation part 260 is exposed to the outside.

In this way, when the battery disconnect device 200 is installed in a housing of a battery pack, the heat dissipation part 260 is exposed to the outside so as to be in direct contact with the housing of the battery pack, so that heat of the heat dissipation part 260 is transferred to the battery pack, thereby improving the performance of the heat dissipation part 260.

As shown in FIG. 11, the heat dissipation part 260 may include a plurality of heat dissipation fins formed parallel to one another.

Heat dissipation holes 260a through which external air moves are formed between the plurality of heat dissipation fins. The external air can absorb heat from the substrate (150, see FIG. 2) through the heat dissipation holes 260a and be discharged to the outside again through the heat dissipation holes 260a.

An end 260b of the heat dissipation part 260 may be positioned higher than an end 110b of the body part 110. That is, as the heat dissipation part 260 is accommodated in the accommodation space 118, the heat dissipation part 260 can be suppressed from coming in contact with the battery structure.

As the heat dissipation part 260 does not come into contact with the battery structure, the performance deterioration of the heat dissipation part 260 can be suppressed. This can further suppress the heat dissipation part 260 from thermally affecting the battery structure.

Although the embodiment of the disclosure has been described, the idea of the disclosure is not limited to the embodiment presented in this specification, and those skilled in the art who understand the scope of the disclosure can easily propose other embodiments by addition, change, deletion, etc. of components within the scope of the same technical idea, but it should be understood that those addition, change, deletion, etc. are embraced within the technical idea of the disclosure.
100: Battery disconnect device
110: Body part
141: Relay
150: Substrate
160: Heat dissipation part

## Claims

1. A battery disconnect device comprising:
a body part on which a relay is mounted, the relay being configured to cut off or supply electricity; and
a substrate coupled to one surface of the body part, electrically connected to the relay, and comprising a controller configured to control whether the relay cuts off or supplies electricity.

2. The battery disconnect device of claim 1, further comprising a heat dissipation part arranged on one surface of the substrate and configured to protect the substrate or dissipate heat to outside.

3. The battery disconnect device of claim 2, wherein the body part comprises first body holes communicating with the heat dissipation part.

4. The battery disconnect device of claim 1, wherein the substrate is coupled to a lower side of the body part.

5. The battery disconnect device of claim 2, further comprising a first cover covering the one surface of the body part, and
the heat dissipation part is arranged on another surface of the body part.

6. The battery disconnect device of claim 5, wherein the first cover comprises cover holes through which heat is dissipated, and
the heat dissipation part comprises dissipation holes through which heat is dissipated.

7. The battery disconnect device of claim 2, wherein the relay comprises a terminal protruding to be directly connected to the substrate through the body part, and
the substrate comprises a connecting portion connected to the terminal.

8. The battery disconnect device of claim 7, wherein the body part comprises a second body hole through which the terminal passes.

9. The battery disconnect device of claim 7, wherein the terminal is arranged as a plurality of terminals, and
the connecting portion comprises:
a first connecting portion coupled to the substrate;
a second connecting portion extending from one side of the first connecting portion and formed to surround one of the plurality of terminals; and
a third connecting portion extending from another side of the second connecting portion and formed to surround another one of the plurality of terminals.

10. The battery disconnect device of claim 2, wherein the body part comprises:
a relay installation portion formed to surround at least one surface of the relay; and
a relay cover portion covering the relay.

11. The battery disconnect device of claim 10, wherein the body part further comprises a fixing protrusion arranged inside the relay installation portion, and
the fixing protrusion is formed to protrude from the body part and fix the relay.

12. The battery disconnect device of claim 11, wherein the fixing protrusion comprises:
a first fixing protrusion coming into contact with one surface of a corner of the relay; and
a second fixing protrusion extending from the first fixing protrusion and coming into contact with another surface of the corner of the relay.

13. The battery disconnect device of claim 10, wherein the relay installation portion comprises a first coupling member for coupling with the relay cover portion,
the relay cover portion comprises a second coupling member coupled to the first coupling member, and
the relay cover portion is coupled to the relay installation portion by coupling the first coupling member and the second coupling member.

14. The battery disconnect device of claim 2, wherein the body part has an accommodation space that accommodates the heat dissipation part, and
an end of the heat dissipation part is located at a higher position than an end of the body part.

15. The battery disconnect device of claim 2, wherein the heat dissipation part is exposed to outside.

16. A method of manufacturing a battery disconnect device, the method comprises:
a body part preparation step of preparing a body part having a relay installation portion on which a relay is mounted;
a substrate coupling step of coupling a substrate comprising a controller to one surface of the body part, the controller being configured to control whether the relay cuts off or supplies electricity;
a relay mounting step of mounting the relay on the relay installation portion; and
a relay covering step of covering a relay cover portion on the relay.

17. The method of claim of claim 16, further comprising a heat dissipation part arrangement step of arranging a heat dissipation part on the substrate, the heat dissipation part dissipating heat to outside.
